# EUROPEAN PATENT SPECIFICATION

(11) **EP 0 489 703 B1**
(45) Date of publication and mention of the grant of the patent: **07.02.1996**
(21) Application number: 91870193.9
(22) Date of filing: 04.12.1991
(51) Int. Cl.: H01L 39/24, C04B 35/00

(54) **Method to form a superconductive ceramic product and the product thus obtained and the intermediate product**
Verfahren zur Herstellen eines supraleitenden keramischen Produkts und das damit erzeugte Produkt und das Zwischenprodukt
Méthode pour la fabrication d'un produit superconducteur en céramique et le produit obtenu de cette manière et le produit intermédiaire

(30) Priority: 04.12.1990 BE 9001149
(43) Date of publication of application: 10.06.1992
(73) Proprietor: "VLAAMSE INSTELLING VOOR TECHNOLOGISCH ONDERZOEK", afgekort "V.I.T.O.", B-2400 Mol (BE)
(72) Inventor: Adriansens, Walter, B-2400 Mol (BE); Weyten, Herman, B-2100 Deurne (BE); Doyen, Willy, B-2220 Wommelgem (BE); Cornelis, Jozef, B-2360 Oud Turnhout (BE); Leysen, Roger, B-2400 Mol (BE)
(74) Representative: Debrabandere, René

(56) References cited:
- EP-A- 0 306 032
- PROCEEDINGS OF THE 38TH ELECTRONICS COMPONENTS CONFERENCE, 9-11 May 1988, pages 176-80, IEEE, New York, NY, USA; Pope, E.J.A. et al.:"Metalorganic polymer route to superconducting yttrium barium-copper-oxide wire"

## Description

The invention relates to a method for the realization of a superconductive ceramic product, according to which a suspension is produced of an organic solvent, an organic polymer binding agent and a superconductor- powder, this is a superconductive powder or a superconductor- precursor of a mixture of powders becoming superconductive after a thermal treatment, or a mixture of two or more of these materials, the suspension is brought to the desired form, the solvent is removed from the suspension, the binding agent is removed thermally and the obtained product is then subjected to a thermal treatment.

It is generally known that such ceramic powders based on yttrium, bismuth or thallium show superconductive properties already at temperatures higher than those of liquid helium and even of liquid nitrogen. In this respect yttrium-barium-copper oxide is appropriate.

These superconductive powders, in the practical application, must be brought into a usable shape such as wire, film or tape, which due to the non flexible character of ceramic materials, may create problems.

EP-A-0 341 030 describes a method of aforementioned kind to from superconductive products such as wire. A suspension is developed from a superconduct or-powder, in fact a so-called superconductor oxide precursor, in a watery solution of a water soluble polymer.

After extrusion of the suspension into wire, it is dried and treated thermally during which the polymer disappears and a certain sintering takes place. The mechanical properties of the wire leave a lot to be desired.

Another method of aforementioned kind is described in EP-A-0 341 030. According to this method a suspension is prepared with yttrium-barium-copper oxide powder, a perfluoroisobutyle acrylate polymer as binding agent and methyl ethyl ketone as organic solvent. This suspension is applied as a film on a substrate, the solvent is evaporated, the polymer is removed thermally and the film is then further thermally treated at 900 degrees Celsius in an oxygen atmosphere.

The invention aims to provide a method of the aforementioned kind in which a superconductive product and, more particularly, wire, film or tape, with very good mechanical properties can be obtained in a simple manner.

With this aim in mind, polysulphone is used as organic binding agent and the solvent is removed from the suspension brought into form by means of extraction with a non solvent.

The removal of a solvent by means of extraction with a non solvent is known as such. Surprisingly so it appeared that by application of such an extraction combined with the use of polysulphone as an organic binding agent a very rapid crystallization of the binding agent is obtained which is especially advantageous with uninterrupted forming methods such as extrusion and wire spinning and where a finished product with good mechanical properties is obtained.

In a special embodiment of the invention an organic and silicone free thixotropic agent is added to said suspension, before the forming of the suspension, said agent being removed together with the binding agent during the thermal removal process.

In a remarkable embodiment of the invention the weight ratio of polysulphone to solvent in the suspension is between 10 and 40 %.

In an effective embodiment of the invention the polysulphone is first mixed with the solvent and this mixture is then mixed with the superconductor- powder.

The weight ratio polysulphone to superconductor- powder is then preferably between 2 and 30%

A very suitable superconductive powder is a powder based on yttrium, bismuth or thallium and, for instance, yttrium-barium-copper oxide : YBa₂Cu₃O_{(7-δ)} (YBCO).

In a preferably applied embodiment of the invention the binding agent is thermally removed from the suspension by keeping it under a vacuum at a temperature of 200 to 700 degrees Celsius during a period up to five hours.

The thermal treatment includes preferably the sintering at a temperature of 800-1000 degrees Celsius and a calcination under an oxygen or air atmosphere at a temperature of 400 to 500 degrees Celsius.

One additive at least can be added to the suspension for the improvement of the mechanical and/or superconductive properties.

The inventions also relates to the formed ceramic superconductive product obtained according to the method according to one of the former embodiments.

The invention, finally, also relates to the intermediate product obtained after the removal of the solvent, which intermediate product as such can be brought on the market for further treatments.

Other particularities and advantages of the invention will appear from the following description of a method to form a superconductive ceramic product and of the thus obtained product or intermediate product according to the invention. This description serves only as an example and does not limit the scope of the invention.

In order to prepare a superconductive ceramic film or wire or a superconductive tape based on superconductive ceramic powder based on yttrium, bismuth or thallium, a suspension of this powder is prepared in a solution of polysulphone in an organic solvent, the suspension is brought into the required form, the solvent is removed by extraction with a non solvent, the polysulphone is thermally removed and a thermal treatment is then further applied with a sintering and a calcination in an oxygen or air atmosphere.

Polysulphone with an ash contents of less than 0.1 % is used as a temporary polymer binding agent, such as for instance the type P 1800 NT of Union Carbide which possesses an extremely low residue ash contents of 0.08%. Other temporary binding agents used in known methods for the preparation of formed superconductive products such as polyvinylalcohol and hydroxypropylcellulose possess a higher residue ash contents.

The organic solvent in which the polysulphone dilutes must possess a sufficiently high boiling point (60 degrees Celsius or higher) in order to avoid that the suspension brought into form would unmix as a consequence of evaporation before the extraction of the solvent occurs.

The ratio polysulphone to solvent varies between 10 and 40 percent of weight in accordance with the required viscosity needed for the formation. Adequate solvents are, among others, N-Methyl-2-pyrrolidone, dimethylformamide and dimethylacetamide.

If the average grain size of the superconductive oxide is too large the oxide powder is submitted to wet breaking in an anhydrous suspension, for instance in anhydrous alcohol until the grain size preferably is between 1 and 15 micrometers. A ball mill is used for breaking small quantities. The suspension must be anhydrous in order to avoid that the powder reacts with water.

The possibly broken superconductive ceramic powder is mixed with the polysulphone solution for instance in a ball mill in which a de-agglomeration occurs. The weight ratio polysulphone/superconductive powder is situated between 2 and 30%. This high degree of filler is required in order to permit sintering at a later stage and to obtain a sufficient mechanical strength after sintering.

The viscosity of the obtained suspension varies between S centipoise and 20,000 centipoise. In case the formation of the suspension occurs by brushing of spraying only a few centipoises suffice but for a formation by extrusion the viscosity must remain between 10,000 and 20,000 centipoise. The viscosity is adjusted by adapting the ratio solvent to polysulphone.

One possibly can, prior to shaping, add up to maximum 1 percent of weight of an organic and silicium free thixotropic agent to the obtained suspension. A thixotropic agent is a stabilizer producing web formation by means of an H-binding and creating a high viscosity in a state of rest. In the case of strong movement of the product to which the agent is added, the viscosity is low but the viscosity will increase to the rest value again shortly after recovery of the state of rest. This agent avoids the precipitation of the superconductive powder. This agent will be removed thermally later on together with the poiymer binding agent. This agent may increase the residual ash contents with 0.05 % maximum which means that the asn contents of the thixotropic agent itself may amount to 5 % maximum. The agent must absolutely be free of silicium as silicium has a negative influence on the superconductive properties of the superconductive product.

The suspension is brought into the required form by means of the usual techniques. In order to form a film the suspension is for instance applied to a substrate by means of spraying, brushing or immersion. In order to prepare a tape, the so-called "doctor blade" method can be used. Wire can be prepared by spinning or extrusion.

After this modelling the solvent is removed by immersion of the formed suspension in a non solvent, more particularly isopropanol or pentanol during at least 5 minutes, for instance during 5 minutes to 24 hours. Water only cannot be used as a non solvent unless very briefly and followed by an immersion in an organic non solvent, as the immersion period cannot be chosen long enough due to the negative effect of water on the superconductive powder. The non solvent must be protected from air in order to limit contamination.

After removal by extraction of the solvent the porosity or the product amounts to 30 to 90 %. This product, called a green product, must be stored in a controlled atmosphere in order to avoid contamination by air humidity.

The polysulphone is now removed from the green product by heating it in a vacuum during 2 to 5 hours between 380 and 500 degrees Celsius. The polysulphone starts to dissolve at 390 degrees Celsius and is normally completely dissolved at 500 degrees Celsius. Vacuum is required to avoid that the thermal decomposition products would chemically or physically compound with the superconductive powder. After removal of the polysulphone, the product is cooled to room temperature.

Finally, the product is subjected to a thermal treatment including a sintering process. In a first phase, the product is heated from room temperature to 800-1000 degrees Celsius in an oxygen or air atmosphere and mostly for a period of 1 to 72 hours. Thereafter the product remains during a certain period of time with a maximum of 72 hours (for instance 1 to 72 hours) in this oxygen or air atmosphere at said temperature. It is principally during this phase that sintering takes place.

In a third phase the product is slowly cooled down, for instance to a temperature of 400 to 500 degrees, for instance 450 degrees Celsius and the product is calcinated for a period of 1 to 72 hours at this temperature. More particularly during this last period of time which also takes place in an oxygen or air atmosphere, oxygen is absorbed so that the adequate oxygen stoichiometry is obtained.

Instead of starting from a superconductive ceramic powder, more particularly a superconductive oxide, one may start from a so-called superconductive precursor which, during the thermal treatment in superconductive powder, is transformed to for instance superconductive oxide, or one may start with a mixture of powders which become superconductive after thermal treatment, such as a mixture of oxide and carbonate, or for instance a mixture of barium-copper oxide ant yttrium-copper oxide. Obviously one can start from a mixture of two or more of the three aforementioned materials.

One or more additives can be added to the suspension which improve the mechanical and superconductive properties, such as silver and/or silver oxide.

The invention will be further clarified by means of the following examples.

### Example 1.

20 grams polysulphone (type P 1800 NT11 from Union Carbide) were dissolved at room temperature in a ball mill in 80 grams N-Methyl-2-pyrrolidone.

25 g of this solution were mixed in a ball mill with 45 g yttrium-barium-copper oxide (YBCO) powder (type SU from Rhône-Poulenc).

The thus obtained suspension was sent through a spinning head with a flange opening of 1 mm. diameter and the formed wire was directly immersed in a bath filled with isopropanol where it was left during two hours.

The green product was placed on a small aluminum plate in an oven and heated to 430 degrees Celsius at a vacuum of 28 kPa. Said product was kept at this temperature during two hours and later cooled down to room temperature.

The product was then heated in an oven filled with oxygen in a period of three hours to 940 degrees Celsius and maintained during 12 hours at this temperature. Finally, during a period of 4 hours the oven was cooled down to a temperature of 450 degrees Celsius and kept at this constant temperature during two hours.

The sintered wire which finally was removed from the oven possessed a diameter of 0.75 mm and a critical temperature of 88 degrees Kelvin and a critical current density of 125 A/cm at 77 degrees Kelvin.

### Example 2.

20 g polysulphone (type P 1800 NT11 from Union Carbide) were dissolved at room temperature in a ball mill in 113.3 g N-Methyl-2-pyrrolidone.

Superconductive YBa₂Cu₃O_{(7-δ)} powder with an average grain size of 6.5 micrometers was mixed with ethanol. The mixture was broken during two hours in a ball mill followed by an evaporation of the ethanol at 60 degrees Celsius. The average grain size after breaking was 4.5 micrometer.

45 g of this powder was mixed in a mill tube with 33.3 g of the polysulphone solution.

The obtained suspension was poured into a casting head with a blade opening adjusted at 600 micrometer. This casting head was moved at a constant speed of 0.05 m/s over a glass plate. Immediately after casting the suspension said giass plate was immersed in an isopropanol bath and remained in it for two hours. A green product with a thickness of 0.320 mm and a porosity of 62 % was obtained.

Said green product was placed in an oven on an aluminumoxide plate and heated up to 430 degrees Celsius at a vacuum of 28 kPa. This temperature was constantly maintained during three hours after which the product was cooled down to room temperature.

After this treatment, the oven was filled with oxygen and heated in three hours to 940 degrees Celsius. This temperature was kept constant for 12 hours after which the oven was cooled down to 450 degrees Celsius. Said temperature was kept constant for 2 hours.

The obtained sintered tape had a thickness of 275 micrometer and a Hg-porosity of 47 % with an average pore size of 1598 nm. The critical temperature of this tape was 83 degrees Kelvin.

### Example 3.

Example 2 was repeated but with pentanoi as a non solvent instead of iso-propanol.

The thickness of the green product was 320 micrometer with a porosity of 62 %, after sintering the Hg porosity amounted to 47 % with an average pore size of 1398 nm.

Contrary to example 2 where a fully opened porosity was noticed, a 3 % closed porosity was measured in this example.

### Example 4.

20 g polysulphone (Type P 1800 NT from Union Carbide) were dissolved at room temperature in 122.65 g of N-Methyl-2-pyrrolidone.

A quantity of superconductive Bi₂Sr₂CaCu₂Oₓ powder from Hoechst with a grain size smaller than 125 micrometer was mixed with ethanol and broken during 3 hours at 100 r.p.m. in a planetary ball mill. The ethanol was dried at 60 degrees Celsius in a drying kiln.

45 g of this powder was mixed in a ball mill with 19.9 g of the polysulphone solution and a thin layer was cast on a glass plate by means of a casting head with a blade opening adjusted at 600 micrometer and moving at a constant speed of 0.05 m/sec.

Immediately thereafter the glass plate was immersed in an isopropanol bath for two hours.

The obtained green product was subsequently placed in an oven on an aluminumoxide plate after which the oven was heated up to 430 degrees Celsius in a vacuum of 28 kPa.

Said temperature was kept constant during 2 hours after which a cooling down to room temperature occurred. The oven was then subsequently filled with air and heated up in 30 minutes to 860 degrees Celsius. The oven was kept at that temperature during 48 hours and thereafter cooled down within a few minutes to room temperature. The obtained sintered tape had a thickness of 150 micrometer. The critical temperature of this tape was 84 degrees Kelvin.

### Example 5.

250 grams polysulphone (type P 1800 NT11 from Union Carbide) were dissolved in a High Speed Dissolver at room temperature in 750 grams N-Methyl-2-pyrrolidone.

20 g of this soiution was then mixed in a ball mill with 44.5 g yttrium-barium-copper oxide (YBCO) superconductive powder (Hoechst Hign. Chem.) with an average grain size of 3 micrometer and with 4.5 g silver oxide powder.

The thus obtained suspension was sent through a spinning head with a flange opening of 1 mm. diameter and the formed wire was directly immersed in water and afterward in a bath filled with isopropanol where it was left during two hours at least.

This so-called "green product" was placed on an aluminum oxide plate in an oven and heated to 440 degrees Celsius in a vacuum of 10 Pa, kept at that temperature during four hours and thereafter heated up to 820 degrees Celcius at an oxygen pressure of 0.6 kPa. After three hours at this pressure and temperature, the oxygen pressure was increased to 100 kPa and the same temperature maintained during 6 hours.

The product was thereafter heated up in this oven at 100 kPa oxygen pressure during a period of three hours to 955 degrees Celcius and kept during twelve hours at this temperature. Finally, the oven was cooled down over a period of seven hours to 450 degrees Celcius and kept constant at this temperature during ten hours.

The sintered wire which was finally removed from the oven had a diameter of 0.75 mm and the superconductive properties above liquid nitrogen temperature could be shown by means of the Meissner effect and electric measurements. The critical current density was of 310 A/cm.

## Claims

1. Method of forming a superconductive ceramic product, according to which a suspension is formed of an organic solvent, an organic polymer binding agent and a superconductor- powder, being a superconductor- powder or a superconductor- precursor or a mixture of powders becoming superconductive after a thermal treatment, or a mixture of two or more of these materials, this suspension is brought into the required form, the solvent is removed from the suspension, the binding agent is removed thermally and the then obtained product undergoes a thermal treatment. characterized in that polysulphone is used as an organic binding agent and the solvent is removed from the suspension brought into form,by means of extraction with a non solvent.

2. Method according to the aforementioned claim, characterized in that before the suspension is brought into form, an organic and a silicium-free thixotropic product is added, said product being removed as well during the thermal removal of the binding agent.

3. Method according to one of the aforementioned claims, characterized in that the weight ratio polysulphone to solvent in the suspension lies between 10 and 40 %.

4. Method according to one of the aforementioned claims, characterized in that a polysulphone to superconductor-powaer weight ratio between 2 and 30 % is chosen.

5. Method according to one of the aforementioned conclusions characterized in that a polysulfone with an ash content lower than 0.1 % is used.

6. Method according to one of the aforementioned claims, characterized in that an organic solvent is used from the group formed by N-methyl-2-pyrrolidone, dimethylformamide and dimethylacetamide.

7. Method according to one of the aforementioned claims, characterized in that a superconduct or- powder is used with an average grain size between 1 and 15 micrometer.

8. Method according to one of the aforementioned claims, characterized in that a powder based on yttrium, bismuth or thallium is used as a superconductor-powder.

9. Method according to one of the aforementioned claims, characterized in that an alcohol is used as a non solvent.

10. Method according to one of the claims 1 to 8, characterized in that water is briefly used as a non solvent followed by the immersion of the obtained product in an organic non solvent.

11. Method according to one of the aforementioned claims, characterized in that the extraction is performed by immersion of the formed suspension in a bath of a non solvent during 5 minutes to 24 hours.

12. Method according to one of the aforementioned claims, characterized in that the binding agent is removed thermally from the suspension by keeping it during a period of time up to 5 hours at a temperature of 200 to 700 degrees Celsius in a vacuum.

13. Method according to one of the aforementioned claims, characterized in that the thermal treatment includes a sintering at a temperature of 800 to 1000 degrees Celcius and a calcination in an oxygen or air atmosphere at a temperature of 400 to 500 degrees Celsius.

14. Method according to the aforementioned claim, characterized in that the sintering in an oxygen or air atmosphere is performed as well and, moreover, that the product is kept at a temperature of 800 to 1000 degrees Celsius from a few hours to a few days.

15. Method according to the aforementioned claim, characterized in that after the sintering the product is cooled down to 400-500 degrees Celsius and is kept at this temperature in an oxygen or air atmosphere up to 72 hours.

16. Method according to one of the aforementioned claims, characterized in that at least one additive is added to the suspension for the improvement of the mechanical and/or superconductive properties.

17. Method according to the aforementioned claim, characterized in that silver and/or silver oxide is added as an additive.

18. Intermediate product obtained through the method according to one of the aforementioned claims after extraction of the solvent from the suspension brought into form said intermediate product comprising the polysulphone as an organic binding agent.

## Patentansprüche

1. Verfahren der Herstellung eines supraleitenden keramischen Produkts, gemäß dessen eine Suspension gebildet wird aus einem organischen Lösungsmittel, einem organischen Polymerbindemittel und einem Supraleiterpulver, das ein supraleitendes Pulver oder ein Supraleiter-Vorläufer aus einer Mischung von Pulvern, die nach einer thermischen Behandlung supraleitend werden, ist, oder einer Mischung von zwei oder mehr dieser Materialien, diese Suspension in die erforderliche Form gebracht wird, das Lösungsmittel aus der Suspension entfernt wird, das Bindemittel auf thermischem Weg entfernt wird und das dann erhaltene Produkt einer thermischen Behandlung unterworfen wird, dadurch gekennzeichnet, daß Polysulphon als organisches Bindemittel verwendet wird und das Lösungsmittel aus der in Form gebrachten Suspension mittels Extraktion mit einem Nicht-Lösungsmittel entfernt wird.

2. Verfahren gemäß dem vorgenannten Anspruch, dadurch gekennzeichnet, daß, bevor die Suspension in Form gebracht wird, ein organisches und ein siliziumfreies thixotropes Produkt hinzugefügt werden, wobei besagtes Produkt ebenfalls während des thermischen Entfernens des Bindemittels entfernt wird.

3. Verfahren gemäß einem der vorgenannten Ansprüche, dadurch gekennzeichnet, daß das Gewichtsverhältnis von Polysulphon zu Lösungsmittel in der Suspension zwischen 10 und 40 % liegt.

4. Verfahren gemäß einem der vorgenannten Ansprüche, dadurch gekennzeichnet, daß ein Polysulphon-zu Supraleiterpulver-Gewichtsverhältnis zwischen 2 und 30 % gewählt wird.

5. Verfahren gemäß einem der vorgenannten Ansprüche, dadurch gekennzeichnet, daß ein Polysulphon mit einem Aschegehalt von weniger als 0,1 % verwendet wird.

6. Verfahren gemäß einem der vorgenannten Ansprüche, dadurch gekennzeichnet, daß ein organisches Lösungsmittel aus der Gruppe, gebildet durch N-Methyl-2-Pyrrolidon, Dimethylformamid und Dimethylacetamid, verwendet wird.

7. Verfahren gemäß einem der vorgenannten Ansprüche, dadurch gekennzeichnet, daß ein Supraleiter-Pulver mit einer durchschnittlichen Korngröße zwischen 1 und 15 Mikrometer verwendet wird.

8. Verfahren gemäß einem der vorgenannten Ansprüche, dadurch gekennzeichnet, daß ein Pulver auf Basis von Yttrium, Wismut oder Thallium als Supraleiter-Pulver verwendet wird.

9. Verfahren gemäß einem der vorgenannten Ansprüche, dadurch gekennzeichnet, daß ein Alkohol als Nicht-Lösungsmittel verwendet wird.

10. Verfahren gemäß einem der Ansprüche 1 bis 8, dadurch gekennzeichnet, daß Wasser kurzfristig als Nicht-Lösungsmittel verwendet wird, gefolgt vom Eintauchen des erhaltenen Produkts in ein organisches Nicht-Lösungsmittel.

11. Verfahren gemäß einem der vorgenannten Ansprüche, dadurch gekennzeichnet, daß die Extraktion durch Eintauchen der gebildeten Suspension in ein Bad eines Nicht-Lösungsmittels während 5 Minuten bis 24 Stunden durchgeführt wird.

12. Verfahren gemäß dem vorgenannten Anspruch, dadurch gekennzeichnet, daß das Bindemittel auf thermischem Weg aus der Suspension entfernt wird, indem sie während einer Zeitspanne bis zu 5 Stunden auf einer Temperatur von 200 bis 700 Grad Celsius in einem Vakuum gehalten wird.

13. Verfahren gemäß einem der vorgenannten Ansprüche, dadurch gekennzeichnet, daß die thermische Behandlung ein Sintern bei einer Temperatur von 800 bis 1000 Grad Celsius und ein Kalzinieren in einer Sauerstoff- oder Luftatmosphäre bei einer Temperatur von 400 bis 500 Grad Celsius beinhaltet.

14. Verfahren gemäß dem vorgenannten Anspruch, dadurch gekennzeichnet, daß das Sintern in einer Sauerstoff- oder Luftatmosphäre ebenfalls durchgeführt wird und, darüber hinaus, daß das Produkt zwischen einigen Stunden bis zu einigen Tagen auf einer Temperatur von 800 bis 1000 Grad Celsius gehalten wird.

15. Verfahren gemäß dem vorgenannten Anspruch, dadurch gekennzeichnet, daß das Produkt nach dem Sintern auf 400-500 Grad Celsius abgekühlt wird und bis zu 72 Stunden in einer Sauerstoff- oder Luftatmosphäre auf dieser Temperatur gehalten wird.

16. Verfahren gemäß einem der vorgenannten Ansprüche, dadurch gekennzeichnet, daß zur Verbesserung der mechanischen und/oder Supraleiteigenschaften der Suspension zumindest ein Additiv zugesetzt wird.

17. Verfahren gemäß dem vorgenannten Anspruch, dadurch gekennzeichnet, daß Silber und/oder Silberoxid als Additiv zugesetzt wird.

18. Zwischenprodukt, erhalten durch das Verfahren gemäß einem der vorgenannten Ansprüche nach Extraktion des Lösungsmittels aus der in Form gebrachten Suspension, wobei besagtes Zwischenprodukt Polysulphon als organisches Bindemittel umfaßt.

## Revendications

1. Procédé de façonnement d'un produit céramique supraconducteur, conformément auquel une suspension est formée à partir d'un solvant organique, d'un liant polymère organique et d'une poudre supraconductrice, à savoir une poudre supraconductrice ou un précurseur supraconducteur ou encore un mélange de poudres qui devient supraconducteur après un traitement thermique, ou bien d'un mélange de deux de ces matières ou plus, cette suspension est amenée à la forme désirée, le solvant est éliminé de la suspension, le liant est éliminé par voie thermique et le produit ainsi obtenu est soumis à un traitement thermique, caractérisé en ce qu'on utilise de la polysulfone comme agent liant organique et on élimine le solvant de la solution amenée à sa forme, par extraction dans un non-solvant.

2. Procédé selon la revendication précédente, caractérisé en ce que, avant d'amener la suspension à sa forme, on ajoute un produit thixotrope organique et exempt de silicium, ledit produit étant également éliminé lors de l'élimination du liant par voie thermique.

3. Procédé selon une quelconque des revendications ci-dessus, caractérisé en ce que le rapport pondéral de la polysulfone au solvant dans la suspension se situe entre 10 et 40%.

4. Procédé selon une quelconque des revendications ci-dessus, caractérisé en ce qu'on sélectionne un rapport pondéral de la polysulfone à la poudre supraconductrice entre 2 et 30%.

5. Procédé selon une quelconque des revendications ci-dessus, caractérisé en ce qu'on utilise une polysulfone possédant une teneur en cendres inférieure à 0,1%.

6. Procédé selon une quelconque des revendications ci-dessus, caractérisé en ce qu'on utilise un solvant organique choisi parmi le groupe formé par la N-méthyl-2-pyrrolidone, le diméthylformamide et le dyméthylacétamide.

7. Procédé selon une quelconque des revendications ci-dessus, caractérisé en ce qu'on utilise une poudre supraconductrice possédant une granulométrie moyenne entre 1 et 15 microns.

8. Procédé selon une quelconque des revendications ci-dessus, caractérisé en ce qu'on utilise, comme poudre supraconductrice, une poudre à base d'yttrium, de bismuth ou de thallium.

9. Procédé selon une quelconque des revendications ci-dessus, caractérisé en ce qu'on utilise un alcool comme non-solvant.

10. Procédé selon une quelconque des revendications 1 à 8, caractérisé en ce qu'on utilise de l'eau pendant un bref laps de temps comme non-solvant, cette utilisation étant suivie de l'immersion du produit obtenu dans un non-solvant organique.

11. Procédé selon une quelconque des revendications ci-dessus, caractérisé en ce qu'on effectue l'extraction par immersion de la suspension façonnée dans un bain d'un non-solvant pendant un laps de temps de 5 minutes à 24 heures.

12. Procédé selon une quelconque des revendications ci-dessus, caractérisé en ce qu'on élimine de la suspension le liant par voie thermique en la maintenant pendant un laps de temps allant jusqu'à 5 heures à une température de 200 à 700 degrés Celsius sous vide.

13. Procédé selon l'une quelconque des revendications ci-dessus, caractérisé en ce que le traitement thermique englobe un frittage à un température de 800 à 1000 degrés Celsius et une calcination dans une atmosphère d'oxygène ou d'air à la température de 400 à 500 degrés Celsius.

14. Procédé selon la revendication ci-dessus, caractérisé en ce que le frittage est réalisé dans une atmosphère d'oxygène ou d'air et, en outre, en ce que le produit est maintenu à une température de 800 à 1000 degrés Celsius pendant un laps de temps allant de quelques heures à quelques jours.

15. Procédé selon la revendication ci-dessus, caractérisé en ce que, après le frittage, on refroidit le produit à une température de 400-500 degrés Celsius et on le maintient à cette température dans une atmosphère d'oxygène ou d'air pendant un laps de temps allant jusqu'à 72 heures.

16. Procédé selon l'une quelconque des revendications ci-dessus, caractérisé en ce qu'on ajoute au moins un additif à la suspension pour améliorer les propriétés mécaniques et/ou supraconductrices.

17. Procédé selon la revendication ci-dessus, caractérisé en ce qu'on ajoute de l'argent et/ou de l'oxyde d'argent comme additif.

18. Produit intermédiaire obtenu par le procédé selon l'une quelconque des revendications ci-dessus, après extraction du solvant de la suspension amenée à sa forme, ledit produit intermédiaire comprenant de la polysulfone comme liant organique.
